# EUROPEAN PATENT SPECIFICATION

(11) **EP 3 034 654 B1**
(45) Date of publication and mention of the grant of the patent: **25.10.2017**
(21) Application number: 14199223.0
(22) Date of filing: 19.12.2014
(51) Int. Cl.: C23F 1/18, H05K 3/06, H05K 3/38

(54) **Composition and method for micro etching of copper and copper alloys**
Zusammensetzung und Verfahren zur Mikroätzung von Kupfer und Kupferlegierungen
Composition et procédé de micro-gravure de cuivre et alliages de cuivre

(43) Date of publication of application: 22.06.2016
(73) Proprietor: Atotech Deutschland GmbH, 10553 Berlin (DE)
(72) Inventor: Lager, Markku, 10243 Berlin (DE); Clicque, Arno, 13435 Berlin (DE); Tews, Dr. Dirk, 10318 Berlin (DE)

(56) References cited:
- EP-A1- 2 241 653
- EP-A1- 2 594 662
- WO-A1-2011/147448

## Description

### Field of the Invention

The present invention relates to a composition for micro etching of a copper or a copper alloy surface; and to a method for micro etching of copper or copper alloy surfaces using such a composition.

### Background of the Invention

With increasing complexity of printed circuit board (PCB) geometry and the variety of copper and copper alloy substrates used in manufacture, good adhesion of imaging resists, e.g., photoresists, and solder masks has become a critical issue. Also due to more severe demands of lead-free production, it has become necessary to withstand the chemical attack of said copper or copper alloy surfaces caused by PCB surface finish processes like immersion tin, immersion silver and ENIG (electroless nickel / immersion gold). Therefore excellent adhesion of imaging resists or solder masks is now an essential prerequisite in order to prevent defects caused by poor imaging film or solder mask adhesion.

Increased adhesion of imaging resists or solder masks on copper or copper alloy surfaces can be achieved by micro etching the copper or copper alloy surface prior to attachment of imaging resists or solder masks. One general type of compositions for said micro etching purpose is disclosed in EP 0 757 118. Such aqueous micro etching compositions comprise a cupric ion source, an organic acid and a source of halide ions.

Document EP 0 855 454 discloses a similar composition further comprising a polymer compound which contains polyamine chains or a cationic group or both. Document EP 2 594 662 A1 discloses a method for micro etching of copper and copper alloys with an aqueous composition comprising a ferric ion source, at least one inorganic acid and at least one etching additive.

Documents WO 2011/147448 A1 and EP 2 241 653 A1 disclose aqueous micro etching compositions for copper and copper alloys comprising a cupric ion source, at least one acid, the sodium salt thereon, at least one etch additive and at least one etch refiner, such as Thioflavin T. The micro etching compositions for copper and copper alloy surfaces known from the prior art provide a uniform and controllable micro roughing of said surfaces but fail to provide a sufficient adhesion of imaging resists and solder masks as demanded for state of the art printed circuit board manufacturing. In particular, the adhesion provided by the above mentioned micro etching compositions for, e.g., solder mask lines spots with a size of ≤ 100 µm or fine line imaging resist patterns with line and space dimensions of ≤ 100 µm is not sufficient any more.

### Objective of the present Invention

Thus, it is the object of the present invention to provide compositions and methods useful for micro etching of copper and copper alloy surfaces in order to promote the adhesion of either imaging resists or solder masks on copper and copper alloy surfaces, in particular for the production of printed circuit boards.

### Summary of the Invention

These objects and also further objects which are not stated explicitly but are immediately derivable or discernible from the connections discussed herein by way of introduction are achieved by a composition having all features of claim 1. Appropriate modifications to the inventive composition are protected in dependent claims 2 to 13. Further, claim 14 comprises a method for micro etching of copper and copper alloy surfaces using such a composition, whereas an appropriate modification of said inventive method is comprised by dependent claim 15.

The present invention accordingly provides a composition for micro etching of a copper or a copper alloy surface, wherein the composition comprises
i) at least a source of Fe³⁺ ions,
ii) at least a source of Br- ions,
iii) at least an inorganic acid, and
iv) at least one etch refiner according to formula I 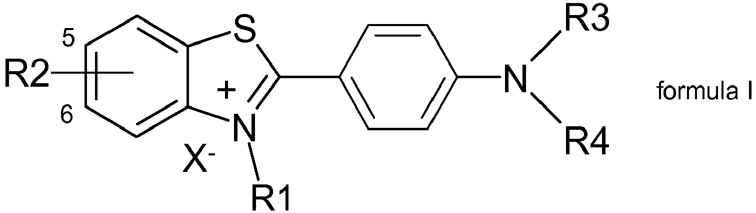 wherein R1 is selected from the group consisting of hydrogen, C₁-C₅-alkyl or a substituted aryl or alkaryl group;
   R2 is selected from the group consisting of hydrogen, C₁-C₅-alkyl or C₁-C₅-alkoxy;
   R3, R4 are selected from the group consisting of hydrogen and C₁-C₅-alkyl;
   and X- is a suitable anion.

It is thus possible in an unforeseeable manner to provide a composition, which can promote the adhesion of either imaging resists or solder masks on copper and copper alloy surfaces by generating a suitable surface roughness of the respective substrates.

### Detailed Description of the Invention

The source of the bromide ions is selected from the group comprising NaBr, KBr, NH₄Br, LiBr and mixtures thereof.

The at least one inorganic acid present in the inventive composition is selected from the group comprising sulfuric acid (H₂SO₄), phosphoric acid (H₃PO₄). Sulfuric acid is preferred. The total amount of acid present in the inventive composition ranges from 0.1 to 500 g/l, more preferred from 1 to 200 g/l.

X⁻ as a suitable anion can be a halide, such as chloride or bromide, wherein chloride is preferred.

In one embodiment, R1 is selected from the group consisting of hydrogen, methyl, ethyl, n-propyl, iso-propyl, phenyl and benzyl; R2 is selected from the group consisting of hydrogen, methyl, ethyl, n-propyl and iso-propyl; R3 is selected from the group consisting of hydrogen, methyl, ethyl, n-propyl and iso-propyl; R4 is selected from the group consisting of hydrogen, methyl, ethyl, n-propyl and iso-propyl.

In another embodiment, the R2 group is in the 5 or 6 position.

In one embodiment, R3 and R4 are the same.

In one embodiment, the etch refiner according to formula I is selected from the group consisting of 4-(6-methyl-1,3-benzothiazol-3-ium-2-yl)-N,N-dimethylaniline chloride, 4-(3-benzyl-6-methyl-1,3-benzothiazol-3-ium-2-yl-N,N-dimethylaniline chloride, 4-(3,6-dimethyl-1,3-benzothiazol-3-ium-2-yl)-N,N-dimethylaniline chloride, 4-(3-benzyl-5-methyl-1,3-benzothiazol-3-ium-2-yl)-N,N-dimethylaniline chloride, 4-(3,5-dimethyl-1,3-benzothiazol-3-ium-2-yl)-N,N-dimethylaniline chloride, 4-(3-methyl-6-ethoxy-1,3-benzothiazol-3-ium-2-yl)-N,N-dimethylaniline chloride, 4-(3-benzyl-1,3-benzothiazol-3-ium-2-yl)-N,N-dimethylaniline chloride, 4-(3-methyl-5-ethoxy-1,3-benzothiazol-3-ium-2-yl)-N,N-dimethylaniline chloride, 4-(3-benzyl-5-ethoxy-1,3-benzothiazol-3-ium-2-yl)-N,N-diemthylaniline chloride, 4-(3-benzyl-5-ethoxy-1,3-benzothiazol-3-ium-2-yl)-N,N-dimethylaniline chloride, 4-(6-methyl-1,3-benzothiazol-3-ium-2-yl)-N,N-diethylaniline chloride, 4-(3-benzyl-6-methyl-1,3-benzothiazol-3-ium-2-yl-N,N-diethylaniline chloride, 4-(3,6-dimethyl-1,3-benzothiazol-3-ium-2-yl)-N,N-diethylaniline chloride, 4-(3-benzyl-5-methyl-1,3-benzothiazol-3-ium-2-yl)-N,N-diethylaniline chloride, 4-(3,5-dimethyl-1,3-benzothiazol-3-ium-2-yl)-N,N-diethylaniline chloride, 4-(3-methyl-6-ethoxy-1,3-benzothiazol-3-ium-2-yl)-N,N-diethylaniline chloride, 4-(3-benzyl-1,3-benzothiazol-3-ium-2-yl)-N,N-diethylaniline chloride, 4-(3-methyl-5-ethoxy-1,3-benzothiazol-3-ium-2-yl)-N,N-diethylaniline chloride, 4-(3-benzyl-5-ethoxy-1,3-benzothiazol-3-ium-2-yl)-N,N-diethylaniline chloride, 4-(3-benzyl-5-ethoxy-1,3-benzothiazol-3-ium-2-yl)-N,N-diethylaniline chloride and mixtures thereof.

Especially preferred from the group of etch refiners according to formula I is 4-(3,6-dimethyl-1,3-benzothiazol-3-ium-2-yl)-N,N-dimethylaniline chloride, which is also known as Thioflavin T.

In a preferred embodiment, the composition further comprises at least one source of Cu²⁺ ions.

Suitable sources of Cu²⁺ ions are selected from the group comprising CuSO₄, CuBr₂, CuO, Cu(OH)₂ and mixtures thereof. The quantity of copper ions in the inventive composition ranges from 1 to 300 g/l, more preferred from 10 to 50 g/l and most preferred from 20 to 40 g/l.

In one embodiment, the composition further comprises at least one source of Fe²⁺ ions.

In a preferred embodiment, the concentration of Fe²⁺ ions and Fe³⁺ ions in the inventive composition are the same.

In one embodiment, the source of Fe²⁺ ions is FeSO₄ and the source of Fe³⁺ ions is Fe₂(SO₄)₃.

The quantity of Fe²⁺ ions and Fe³⁺ ions in the inventive composition ranges from 1 to 100 g/l, preferably from 1 to 50 g/l, and more preferably from 1 to 30 g/l.

The pH value of the inventive composition is less than 3, preferably less than 2, and more preferably less than 1.5.

In another embodiment, the composition comprises less than 100 mg/l, preferably less than 50 mg/l, and more preferably less than 25 mg/l of Cl¹⁻ ions.

In one embodiment, the composition is substantially free of organic acids and organic acid salts.

In one embodiment, the etch refiner according to formula I concentration ranges from 1 to 1000 mg/l, preferably from 1 to 300 mg/l, and more preferably from 1 to 100 mg/l.

In one embodiment, the concentration of Br⁻ ions ranges from 1 to 200 mg/l, preferably from 1 to 100 mg/l, and more preferably from 1 to 25 mg/l.

Imaging resists are photosensitive polymeric systems applied either as liquids or dry films. Solder masks are polymeric material deposits that provide a permanent protective coating for the copper or copper alloy surface of a PCB.

Further, the object of the present invention is also solved by a method for micro etching of copper or copper alloy surfaces using the above described composition in order to enhance the adhesion of an image resist or a solder mask to be attached to said surface. The method is characterized by the following method steps:
i) providing a substrate having a copper or copper alloy surface,
ii) contacting said surface with a cleaner composition,
iii) contacting said surface with a composition according to one of the preceding claims in a first tank,
wherein during contacting copper is oxidized to Cu²⁺ ions and the Cu²⁺ ions are disclosed in said composition, while Fe³⁺ ions are reduced simultaneously to Fe²⁺ ions.

The method according to this invention is carried out by contacting the copper or copper alloy surfaces with aforementioned compositions. The substrate can be immersed into the solution or the solution can be sprayed onto the copper or copper alloy surface of the substrate. For this purpose common horizontal or vertical equipment can be utilized.

Using a spray, the solution is sprayed onto the substrate having a copper or copper alloy surface at a pressure of 1-10 bar.

For both methods (spray or solution) the process is preferably carried out at a temperature ranging from 10 to 60 °C, more preferably from 20 to 50 °C and most preferably from 30 to 45 °C. The treatment time ranges from 10 to 360 s, more preferably from 20 to 200 s and most preferably from 30 to 90 s.

After the copper or copper alloy surface has been treated as such, the copper or copper alloy surfaces are rinsed with water, e.g., deionised water and then dried, e.g., with hot air.

Optionally, the etched copper or copper alloy surfaces can also be treated for 5-300 s with diluted acid after being rinsed, preferably with 10 vol.-% hydrochloric acid or diluted sulphuric acid. After being treated with acid, the copper surfaces are again rinsed, preferably with deionised water.

The samples are preferably treated by spraying the etching compositions according to the invention onto the samples. The compositions can be sprayed in a vertical mode or horizontal mode, depending on the equipment desired. Alternatively, the samples can be immersed into the etching compositions. To achieve the same roughness values compared to spraying, the compositions need to be penetrated by oxygen, e.g., by bubbling air through them.

In a preferred embodiment of the method, the method is characterized in that the method further comprises the method steps:
iv) transferring a portion of said composition after contacting with the substrate to a second tank,
   wherein said second tank comprises an anode and a cathode and
v) reducing said Cu²⁺ ions to copper while oxidizing Fe²⁺ ions to Fe³⁺ ions by applying a current between said anode and said cathode.

During use the composition is enriched in Cu²⁺ ions (they are disposed in the composition according to the present invention). At the same time Fe³⁺ ions are reduced to Fe²⁺ ions. Cu²⁺ ions have a negative impact on the performance of the composition. Cu²⁺ ions increase the density and viscosity of the micro etching solution and thereby negatively effect the micro etching behaviour. The etch rate and side wall etching performance may decrease. Furthermore, precipitation of Cu²⁺ ion complexes can occur. Such precipitates pose a mechanical danger to the equipment and the surfaces coming into contact with the etching composition.

In processes according to prior art some or all of the added Cu²⁺ ions are removed by bleeding (removing) an adequate amount of etching solution and adding (feeding) fresh etching solution to the remaining solution.

One particular method to remove Cu²⁺ ions from a solution is to electrolytically reduce Cu²⁺ ions to metallic copper.

In principle, a second tank equipped with an anode and a cathode and a rectifier is required for electrolysis.

Portions of the composition according to the present invention are transferred from a first tank where or from which the micro etching of copper or a copper alloy layer is performed to a second tank equipped for electrolysis. During electrolysis Cu²⁺ ions are cathodically reduced to metallic copper and at the same time Fe²⁺ ions are oxidised anodically to Fe³⁺ ions.

The metallic copper can be collected and recycled. Without an electrolytic regeneration cell the oxidizing agent (Fe³⁺ ions) would need to be continuously added to the micro etching solution. By application of the above described regeneration the spent Fe³⁺ ions are regenerated at the anodes (Fe²⁺ is oxidised to Fe³⁺) and thereby no adding (feeding) of the oxidising agent during use of the etching solution is required.

For such a regeneration cycle, it is mandatory that certain conditions are fulfilled. The pH value has to be low in order to ensure a high dissociation of the inorganic acid of the inventive composition. Therefore, the composition has to be free of any organic acids or organic acid salts, if such a regeneration cycle of such a preferred method is intended to be executed.

Furthermore, it is helpful if the second tank is equipped with a measurement device, which is able to measure, ideally in situ, the concentration of Fe³⁺ ions and Cu²⁺ ions. If the concentration of Fe³⁺ ions becomes too low, the measurement device detect it and initiates subsequent application of current in the second tank in order to start the regeneration of the bath composition being in the second tank. If the concentration of Fe³⁺ ions is still above a predetermined benchmark value, the bath composition does not need yet regeneration. Then, the portion of the bath composition is transferred back to the first tank without any executed electrolysis. A user can set up the predetermined benchmark value in dependence of his system.

The same applies in principle for the concentration of Cu²⁺ ions, which can be measured by such a measurement device. But, in this case the concentration of Cu²⁺ ions is observed to determine if the concentration is too high. If the concentration of Cu²⁺ ions exceeds a predetermined benchmark value, the bath composition needs regeneration in order to plate out Cu²⁺ ions as copper as described above.

In a preferred embodiment of the method, the micro etching composition further comprises right from the beginning a source of Cu²⁺ ions and a source of Fe²⁺ ions, wherein the concentration of the Fe²⁺ ions and the Fe³⁺ ions already comprised by the composition is the same. This generates right from the beginning of the method an equilibrium in the composition for the redox pairs of Fe²⁺/Fe³⁺ and Cu⁰/Cu²⁺, which allows direct initiating of the regeneration cycle.

If the starting composition does not comprise Fe²⁺ ions and Cu²⁺ ions, the micro etching method can be conducted, but not the regeneration cycle due to the absence of these ions. Then, a user has to wait until enough (waiting time period is depending on the predetermined benchmark value) Fe³⁺ ions become reduced to Fe²⁺ ions and/or until enough Cu²⁺ ions become generated by oxidising copper from the copper surface of the substrate, which is treated by the micro etching composition in method step iii).

A measurement device is selected from the group comprising spectroscopic devices, preferably UV spectroscopic devices, and titration, preferably online UV titration, devices.

The present invention thus addresses the problem of improving the adhesion of either imaging resists or solder masks on copper and copper alloy surfaces, in particular in the production of printed circuit boards.

The following non-limiting examples are provided to illustrate an embodiment of the present invention and to facilitate understanding of the invention.

### Examples

The performance roughness values of copper surfaces micro etched with different compositions, which are within or without the scope of the appended claims, were determined using an atomic force microscope. A copper clad laminate substrate (CCI) was used throughout experiments 1 to 4, respectively. The measurement window was 10 µm x 10 µm.

The process sequence used throughout experiments 1 to 4 was
1. cleaning of the copper surface (Softclean UC 168, a product of Atotech Deutschland GmbH, , t = 20 s, T = 35 °C)
2. micro etching of the copper surface by spraying the micro etching compositions onto the copper substrates
3. drying of the micro etched copper surface
4. determining the copper surface roughness with an atomic force microscope (AFM)

The copper surface micro etch depth was adjusted to 1 µm in examples 1 to 4. The resulting performance roughness values obtained from experiments 1 to 4 are summarized in table 1 (see below).

Different micro etching compositions are contacted with a CCI type substrate for 40 s at a temperature of 35 °C. The micro etching compositions consists of

| | |
|---|---|
| CuSO₄ | 30 g/l (related to Cu²⁺ ions) |
| FeSO₄ | 15 g/l (related to Fe²⁺ ions) |
| Fe₂(SO₄)₃ | 15 g/l (related to Fe³⁺ ions) |
| Sulfuric acid (50%) | 160 ml/l |
| NaCl | 10 mg/l (related to Cl¹⁻ ions) |
| NaBr | 0 or 8 mg/l (related to Br⁻ ions) |
| Thioflavin T | 0 or 5 or 200 mg/l |

**Table 1: performance roughness values obtained from examples 1 to 4.**

| **Experiment no.** | **[Cl¹⁻]** | **[Br⁻]** | **[Thioflavin T]** | **RSAI* (%)** |
|---|---|---|---|---|
| 1 | 10 | 0 | 5 | 8.1 |
| 2 | 10 | 8 | 0 | 8.5 |
| 3 (invention) | 10 | 8 | 200 | 23.1 |
| 4 (invention) | 10 | 8 | 5 | 33.0 |

| | | | | |
|---|---|---|---|---|
| * RSAI = relative surface area increase | | | | |

The copper surface roughness representing parameter RSAI obtained by atomic force microscopy show the highest values for the inventive composition according to examples 3 and 4 compared to compositions being outside the scope of the appended claims (examples 1 and 2). Especially, it is clearly demonstrated that the presence of a certain etch refiner according to formula I and the presence of a source of bromide ions is required to obtain amended surface roughness values. At the same time, it is notable that the constant concentration of chloride ions has obviously, at least at this concentration of 10 mg/l, no remarkable influence on the achieved copper surface roughness.

Different micro etching compositions, which are within or without the scope of the appended claims, have been used for adhesion performance tests wherein a solder mask (Elpemer SG 2467, a product of Peters) is attached to the micro etched copper surfaces in form of crosses. Such a cross consists of geometry of 10 lines x 10 lines, which all have the same diameter. Experiments have been conducted with 5 crosses, wherein the respective diameters of the cross lines of the different crosses are 10 µm, 20 µm, 30 µm, 40 µm and 50 µm. Again, CCI type copper substrates are used. The copper surface micro etch depth is adjusted to 1 µm throughout all experiments.

For the purpose of better detection, the areas between the cross lines have been treated by a selective finishing, in a first series of experiments by immersion tin and in a second series of experiments by ENIG (**E**lectroless **N**ickel **G**old).

An optical qualitative evaluation has been conducted to determine, if the solder mask on the cross lines have been partially or completely removed caused by low adhesion to the underlying copper surface, which has been before roughened by the applied micro etching compositions.

The resulting qualitative evaluation for both series of experiments has been found comparable overall and is summarized in table 2 (see below).

Different micro etching compositions are contacted with a CCI type substrate for 40 s at a temperature of 35 °C. The micro etching compositions consists of

| | |
|---|---|
| CuSO₄ | 30 g/l (related to Cu²⁺ ions) |
| FeSO₄ | 15 g/l (related to Fe²⁺ ions) |
| Fe₂(SO₄)₃ | 15 g/l (related to Fe³⁺ ions) |
| Sulfuric acid (50%) | 160 ml/l |
| NaCl | 10 mg/l (related to Cl¹⁻ ions) |
| NaBr | 0 or 8 or 100 mg/l (related to Br⁻ ions) |
| Thioflavin T | 0 or 5 or 200 mg/l |

**Table 2: Optical qualitative evaluation of solder mask adhesion on copper surfaces roughened before by different micro etching compositions.**

| **Experiment no.** | **[Cl¹⁻]** | **[Br⁻]** | **[Thioflavin T]** | **Evaluation** |
|---|---|---|---|---|
| 5 | 10 | 0 | 5 | Very Low |
| 6 | 10 | 8 | 0 | Very Low |
| 7 (invention) | 10 | 8 | 200 | Good |
| 8 (invention) | 10 | 8 | 5 | Very Good |
| 9 (invention) | 10 | 100 | 5 | Acceptable |

As can be derived from the Evaluation listed in Table 2, the AFM results are confirmed that the presence of an etch refiner according to formula I and of bromide ions are mandatory in order to achieve a good adhesion of the solder mask on the copper surface, which has been before roughened by the inventive micro etching composition. Even a very high concentration of Thioflavin T of 200 mg/l still delivers good adhesion results.

The adhesion performance of the above-cited two series of experiments has been further analysed for a selected number of individual experiments of Table 2 by applying a tape test according to IPC-TM-650 from 8/97, revision D.

An optical qualitative evaluation has been again conducted to determine, if the solder mask on the cross lines have been partially or completely removed caused by low adhesion to the underlying copper surface, which has been before roughened by the applied micro etching compositions.

The resulting qualitative evaluation for both series of experiments has been found comparable overall and is summarized in table 3 (see below).

**Table 3: Optical qualitative evaluation of solder mask adhesion on roughened copper surfaces after applying tape test.**

| **Experiment no.** | **[Cl¹⁻]** | **[Br⁻]** | **[Thioflavin T]** | **Evaluation** |
|---|---|---|---|---|
| 10 | 10 | 0 | 5 | Very Bad |
| 11 | 10 | 8 | 0 | Very Bad |
| 12 (invention) | 10 | 8 | 5 | Very Good |

The results from Table 3 clearly show the superior adhesion of solder mask on copper surfaces treated with a composition according to the present invention and application of a tape test. While nearly all solder mask lines of the respective crosses independently from their line diameter remain, at least after a qualitative optical evaluation, on the roughened copper surface after executing the tape test; the respective lines of solder mask are removed from the copper surfaces for the micro etching compositions lying outside of the scope of the appended claims.

The results obtained from adhesion tests of solder mask dots on micro etched copper surfaces show a superior performance of the inventive micro etch composition (examples 3, 4, 7, 8, 9, and 12) compared to those of compositions lying outside of the scope of the appended claims (examples 1, 2, 5, 6, 10 and 11). The superior solder mask adhesion performance of the inventive micro etch composition is obvious especially after applying a tape test.

It will be understood that the embodiments described herein are merely exemplary and that a person skilled in the art may make many variations and modifications without departing from the scope of the invention. All such variations and modifications, including those discussed above, are intended to be included within the scope of the invention as defined by the appended claims.

## Claims

1. Composition for micro etching of a copper or a copper alloy surface **characterized in that** the composition comprises
i) at least a source of Fe³⁺ ions,
ii) at least a source of Br- ions,
iii) at least an inorganic acid, and
iv) at least one etch refiner according to formula I 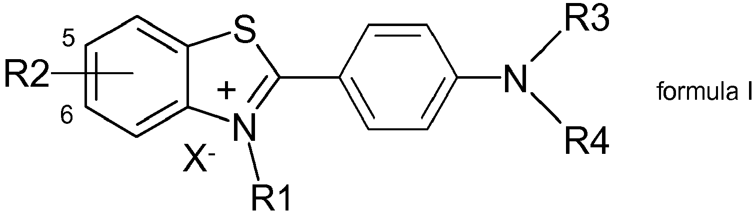 wherein R1 is selected from the group consisting of hydrogen, C₁-C₅-alkyl or a substituted aryl or alkaryl group;
R2 is selected from the group consisting of hydrogen, C₁-C₅-alkyl or C₁-C₅-alkoxy;
R3, R4 are selected from the group consisting of hydrogen and C₁-C₅-alkyl;
and X- is a suitable anion.

2. Composition according to claim 1 **characterized in that**
R1 is selected from the group consisting of hydrogen, methyl, ethyl, n-propyl, iso-propyl, phenyl and benzyl;
R2 is selected from the group consisting of hydrogen, methyl, ethyl, n-propyl and iso-propyl;
R3 is selected from the group consisting of hydrogen, methyl, ethyl, n-propyl and iso-propyl;
R4 is selected from the group consisting of hydrogen, methyl, ethyl, n-propyl and iso-propyl.

3. Composition according to claims 1 or 2 **characterized in that** the R2 group is in the 5 or 6 position.

4. Composition according to one of the preceding claims **characterized in that** R3 and R4 are the same.

5. Composition according to one of the preceding claims **characterized in that** the etch refiner according to formula I is selected from the group consisting of 4-(6-methyl-1,3-benzothiazol-3-ium-2-yl)-N,N-dimethylaniline chloride, 4-(3-benzyl-6-methyl-1,3-benzothiazol-3-ium-2-yl-N,N-dimethylaniline chloride, 4-(3,6-dimethyl-1,3-benzothiazol-3-ium-2-yl)-N,N-dimethylaniline chloride, 4-(3-benzyl-5-methyl-1,3-benzothiazol-3-ium-2-yl)-N,N-dimethylaniline chloride, 4-(3,5-dimethyl-1,3-benzothiazol-3-ium-2-yl)-N,N-dimethylaniline chloride, 4-(3-methyl-6-ethoxy-1,3-benzothiazol-3-ium-2-yl)-N,N-dimethylaniline chloride, 4-(3-benzyl-1,3-benzothiazol-3-ium-2-yl)-N,N-dimethylaniline chloride, 4-(3-methyl-5-ethoxy-1,3-benzothiazol-3-ium-2-yl)-N,N-dimethylaniline chloride, 4-(3-benzyl-5-ethoxy-1,3-benzothiazol-3-ium-2-yl)-N,N-diemthylaniline chloride, 4-(3-benzyl-5-ethoxy-1,3-benzothiazol-3-ium-2-yl)-N,N-dimethylaniline chloride, 4-(6-methyl-1,3-benzothiazol-3-ium-2-yl)-N,N-diethylaniline chloride, 4-(3-benzyl-6-methyl-1,3-benzothiazol-3-ium-2-yl-N,N-diethylaniline chloride, 4-(3,6-dimethyl-1,3-benzothiazol-3-ium-2-yl)-N,N-diethylaniline chloride, 4-(3-benzyl-5-methyl-1,3-benzothiazol-3-ium-2-yl)-N,N-diethylaniline chloride, 4-(3,5-dimethyl-1,3-benzothiazol-3-ium-2-yl)-N,N-diethylaniline chloride, 4-(3-methyl-6-ethoxy-1,3-benzothiazol-3-ium-2-yl)-N,N-diethylaniline chloride, 4-(3-benzyl-1,3-benzothiazol-3-ium-2-yl)-N,N-diethylaniline chloride, 4-(3-methyl-5-ethoxy-1,3-benzothiazol-3-ium-2-yl)-N,N-diethylaniline chloride, 4-(3-benzyl-5-ethoxy-1,3-benzothiazol-3-ium-2-yl)-N,N-diethylaniline chloride, 4-(3-benzyl-5-ethoxy-1,3-benzothiazol-3-ium-2-yl)-N,N-diethylaniline chloride and mixtures thereof.

6. Composition according to one of the preceding claims **characterized in that** the composition further comprises at least one source of Cu²⁺ ions.

7. Composition according to claim 6 **characterized in that** the source of Cu²⁺ ions is selected from the group comprising of CuSO₄, CuBr₂, CuO, Cu(OH)₂ and mixtures thereof.

8. Composition according to one of the preceding claims **characterized in that** the composition further comprises at least one source of Fe²⁺ ions, preferably wherein the concentration of Fe²⁺ ions and Fe³⁺ ions are the same.

9. Composition according to claim 8 **characterized in that** the source of Fe²⁺ ions is FeSO₄ and the source of Fe³⁺ ions is Fe₂(SO₄)₃.

10. Composition according to one of the preceding claims **characterized in that** the composition comprises less than 100 mg/l, preferably less than 50 mg/l, and more preferably less than 25 mg/l of Cl¹⁻ ions.

11. Composition according to one of the preceding claims **characterized in that** the composition is substantially free of organic acids and organic acid salts.

12. Composition according to one of the preceding claims **characterized in that** the etch refiner according to formula I concentration ranges from 1 to 1000 mg/l, preferably from 1 to 300 mg/l, and more preferably from 1 to 100 mg/l.

13. Composition according to one of the preceding claims **characterized in that** the concentration of Br⁻ ions ranges from 1 to 200 mg/l, preferably from 1 to 100 mg/l, and more preferably from 1 to 25 mg/l.

14. Method for micro etching of copper or copper alloy surfaces **characterized by** the following method steps:
i) providing a substrate having a copper or copper alloy surface,
ii) contacting said surface with a cleaner composition,
iii) contacting said surface with a composition according to one of the preceding claims in a first tank,
wherein during contacting copper is oxidized to Cu²⁺ ions and the Cu²⁺ ions are disclosed in said composition, while Fe³⁺ ions are reduced simultaneously to Fe²⁺ ions.

15. Method according to claim 14 **characterized in that** the method further comprises the method steps:
iv) transferring a portion of said composition after contacting with the substrate to a second tank,
wherein said second tank comprises an anode and a cathode and
v) reducing said Cu²⁺ ions to copper while oxidizing Fe²⁺ ions to Fe³⁺ ions by applying a current between said anode and said cathode.

## Patentansprüche

1. Zusammensetzung zum Mikroätzen einer Kupfer- oder Kupferlegierungsoberfläche, **dadurch gekennzeichnet, dass** die Zusammensetzung
i) wenigstens eine Quelle von Fe³⁺-Ionen,
ii) wenigstens eine Quelle von Br⁻-Ionen,
iii) wenigstens eine anorganische Säure und
iv) wenigstens einen Ätz-Refiner gemäß Formel I 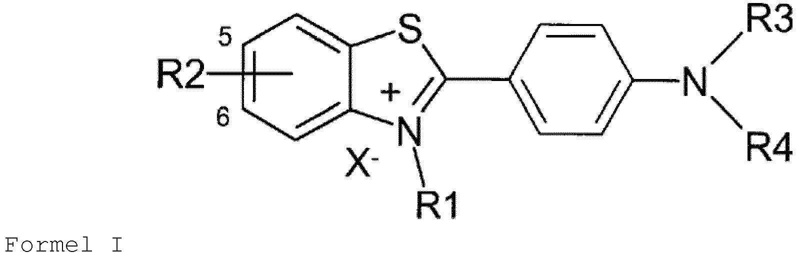 wobei R1 ausgewählt ist aus der Gruppe bestehend aus Wasserstoff, C₁-C₅-Alkyl oder einer substituierten Aryl- oder Alkarylgruppe;
R2 ausgewählt ist aus der Gruppe bestehend aus Wasserstoff, C₁-C₅-Alkyl und C₁-C₅-Alkoxy;
R3 und R4 ausgewählt sind aus der Gruppe bestehend aus Wasserstoff und C₁-C₅-Alkyl;
und X⁻ ein geeignetes Anion ist;
umfasst.

2. Zusammensetzung gemäß Anspruch 1, **dadurch gekennzeichnet, dass**
R1 ausgewählt ist aus der Gruppe bestehend aus Wasserstoff, Methyl, Ethyl, n-Propyl, Isopropyl, Phenyl und Benzyl;
R2 ausgewählt ist aus der Gruppe bestehend aus Wasserstoff, Methyl, Ethyl, n-Propyl und Isopropyl;
R3 ausgewählt ist aus der Gruppe bestehend aus Wasserstoff, Methyl, Ethyl, n-Propyl und Isopropyl;
R4 ausgewählt ist aus der Gruppe bestehend aus Wasserstoff, Methyl, Ethyl, n-Propyl und Isopropyl.

3. Zusammensetzung gemäß Anspruch 1 oder 2, **dadurch gekennzeichnet, dass** die R2-Gruppe an der 5- oder 6-Position angeordnet ist.

4. Zusammensetzung nach einem der vorhergehenden Ansprüche, **dadurch gekennzeichnet, dass** R3 und R4 gleich sind.

5. Zusammensetzung gemäß einem der vorhergehenden Ansprüche, **dadurch gekennzeichnet, dass** der Ätz-Refiner gemäß Formel I ausgewählt ist aus der Gruppe bestehend aus 4-(6-Methyl-1,3-benzothiazol-3-ium-2-yl)-N,N-dimethylanilinchlorid, 4-(3-Benzyl-6-methyl-1,3-benzothiazol-3-ium-2-yl)-N,N-dimethylanilinchlorid, 4-(3,6-Dimethyl-1,3-benzothiazol-3-ium-2-yl)-N,N-dimethylanilinchlorid, 4-(3-Benzyl-5-methyl-1,3-benzothiazol-3-ium-2-yl)-N,N-dimethylanilinchlorid, 4-(3,5-Dimethyl-1,3-benzothiazol-3-ium-2-yl)-N,N-dimethylanilinchlorid, 4-(3-Methyl-6-ethoxy-1,3-benzothiazol-3-ium-2-yl)-N,N-dimethylanilinchlorid, 4-(3-Benzyl-1,3-benzothiazol-3-ium-2-yl)-N,N-dimethylanilinchlorid, 4-(3-Methyl-5-ethoxy-1,3-benzothiazol-3-ium-2-yl)-N,N-dimethylanilinchlorid, 4-(3-Benzyl-5-ethoxy-1,3-benzothiazol-3-ium-2-yl)-N,N-dimethylanilinchlorid, 4-(3-Benzyl-5-ethoxy-1,3-benzothiazol-3-ium-2-yl)-N,N-dimethylanilinchlorid, 4-(6-Methyl-1,3-benzothiazol-3-ium-2-yl)-N,N-diethylanilinchlorid, 4-(3-Benzyl-6-methyl-1,3-benzothiazol-3-ium-2-yl)-N,N-diethylanilinchlorid, 4-(3,6-Dimethyl-1,3-benzothiazol-3-ium-2-yl)-N,N-diethylanilinchlorid, 4-(3-Benzyl-5-methyl-1,3-benzothiazol-3-ium-2-yl)-N,N-diethylanilinchlorid, 4-(3,5-Dimethyl-1,3-benzothiazol-3-ium-2-yl)-N,N-diethylanilinchlorid, 4-(3-Methyl-6-ethoxy-1,3-benzothiazol-3-ium-2-yl)-N,N-diethylanilinchlorid, 4-(3-Benzyl-1,3-benzothiazol-3-ium-2-yl)-N,N-diethylanilinchlorid, 4-(3-Methyl-5-ethoxy-1,3-benzothiazol-3-ium-2-yl)-N,N-diethylanilinchlorid, 4-(3-Benzyl-5-ethoxy-1,3-benzothiazol-3-ium-2-yl)-N,N-diethylanilinchlorid, 4-(3-Benzyl-5-ethoxy-1,3-benzothiazol-3-ium-2-yl)-N,N-diethylanilinchlorid und Gemischen davon.

6. Zusammensetzung gemäß einem der vorhergehenden Ansprüche, **dadurch gekennzeichnet, dass** die Zusammensetzung ferner wenigstens eine Quelle von Cu²⁺-Ionen umfasst.

7. Zusammensetzung gemäß Anspruch 6, **dadurch gekennzeichnet, dass** die Quelle von Cu²⁺-Ionen ausgewählt ist aus der Gruppe bestehend aus CuSO₄, CuBr₂, CuO, Cu(OH)₂ und Gemischen davon.

8. Zusammensetzung gemäß einem der vorhergehenden Ansprüche, **dadurch gekennzeichnet, dass** die Zusammensetzung ferner wenigstens eine Quelle von Fe²⁺-Ionen umfasst, vorzugsweise wobei die Konzentrationen von Fe²⁺-Ionen und Fe³⁺-Ionen gleich sind.

9. Zusammensetzung gemäß Anspruch 8, **dadurch gekennzeichnet, dass** es sich bei der Quelle von Fe²⁺-Ionen um FeSO₄ handelt und es sich bei der Quelle von Fe³⁺-Ionen um Fe₂(SO₄)₃ handelt.

10. Zusammensetzung gemäß einem der vorhergehenden Ansprüche, **dadurch gekennzeichnet, dass** die Zusammensetzung weniger als 100 mg/l, bevorzugt weniger als 50 mg/l und weiter bevorzugt weniger als 25 mg/l Cl¹⁻-Ionen umfasst.

11. Zusammensetzung gemäß einem der vorhergehenden Ansprüche, **dadurch gekennzeichnet, dass** die Zusammensetzung weitgehend frei von organischen Säuren und Salzen organischer Säuren ist.

12. Zusammensetzung gemäß einem der vorhergehenden Ansprüche, **dadurch gekennzeichnet, dass** die Konzentration des Ätz-Refiners gemäß Formel I im Bereich von 1 bis 1000 mg/l, bevorzugt von 1 bis 300 mg/l und weiter bevorzugt von 1 bis 100 mg/l liegt.

13. Zusammensetzung gemäß einem der vorhergehenden Ansprüche, **dadurch gekennzeichnet, dass** die Konzentration von Br⁻-Ionen im Bereich von 1 bis 200 mg/l, bevorzugt von 1 bis 100 mg/l und weiter bevorzugt von 1 bis 25 mg/l liegt.

14. Verfahren zum Mikroätzen von Kupfer- oder Kupferlegierungsoberflächen, **gekennzeichnet durch** die folgenden Verfahrensschritte:
i) Bereitstellen eines Substrats mit einer Kupfer- oder Kupferlegierungsoberfläche,
ii) Inkontaktbringen der Oberfläche mit einer Reinigungszusammensetzung,
iii) Inkontaktbringen der Oberfläche mit einer Zusammensetzung gemäß einem der vorstehenden Ansprüche in einem ersten Tank,
wobei während des Inkontaktbringens Kupfer zu Cu²⁺-Ionen oxidiert wird und die Cu²⁺-Ionen in die Zusammensetzung offenbart werden, während Fe³⁺-Ionen gleichzeitig zu Fe²⁺-Ionen reduziert werden.

15. Verfahren gemäß Anspruch 14, **dadurch gekennzeichnet, dass** das Verfahren ferner die Verfahrensschritte:
iv) Überführen eines Teils der Zusammensetzung nach dem Inkontaktbringen mit dem Substrat in einen zweiten Tank,
wobei der zweite Tank eine Anode und eine Kathode umfasst, und
v) Reduzieren der Cu²⁺-Ionen zu Kupfer bei gleichzeitiger Oxidation von Fe²⁺-Ionen zu Fe³⁺-Ionen durch Anlegen eines Stroms zwischen der Anode und der Kathode
umfasst.

## Revendications

1. Composition pour la microgravure d'une surface de cuivre ou d'alliage de cuivre, **caractérisée en ce que** la composition comprend :
i) au moins une source d'ions Fe³⁺,
ii) au moins une source d'ions Br⁻,
iii) au moins un acide inorganique, et
iv) au moins un agent d'affinage de gravure répondant à la formule I 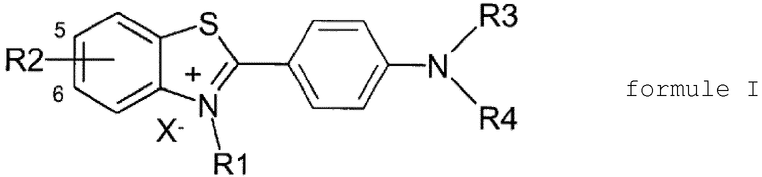 dans laquelle R1 est choisi dans le groupe constitué par l'hydrogène, un alkyle en C₁-C₅ ou un groupe aryle ou alkylaryle substitué ;
R2 est choisi dans le groupe constitué par l'hydrogène, un alkyle en C₁-C₅ ou un alcoxy en C₁-C₅ ;
R3, R4 sont choisis dans le groupe constitué par l'hydrogène et un alkyle en C₁-C₅ ;
et X⁻ est un anion approprié.

2. Composition selon la revendication 1 **caractérisée en ce que**
R1 est choisi dans le groupe constitué par l'hydrogène et les groupes méthyle, éthyle, n-propyle, isopropyle, phényle et benzyle ;
R2 est choisi dans le groupe constitué par l'hydrogène et les groupes méthyle, éthyle, n-propyle et isopropyle ;
R3 est choisi dans le groupe constitué par l'hydrogène et les groupes méthyle, éthyle, n-propyle et isopropyle ;
R4 est choisi dans le groupe constitué par l'hydrogène et les groupes méthyle, éthyle, n-propyle et isopropyle.

3. Composition selon les revendications 1 ou 2 **caractérisée en ce que** le groupe R2 est à la position 5 ou 6.

4. Composition selon une des revendications précédentes **caractérisée en ce que** R3 et R4 sont identiques.

5. Composition selon une des revendications précédentes **caractérisée en ce que** l'agent d'affinage de gravure répondant à la formule I est choisi dans le groupe constitué par le chlorure de 4-(6-méthyl-1,3-benzothiazol-3-ium-2-yl)-N,N-diméthylaniline, le chlorure de 4-(3-benzyl-6-méthyl-1,3-benzothiazol-3-ium-2-yl)-N,N-diméthylaniline, le chlorure de 4-(3,6-diméthyl-1,3-benzothiazol-3-ium-2-yl)-N,N-diméthylaniline, le chlorure de 4-(3-benzyl-5-méthyl-1,3-benzothiazol-3-ium-2-yl)-N,N-diméthylaniline, le chlorure de 4-(3,5-diméthyl-1,3-benzothiazol-3-ium-2-yl)-N,N-diméthylaniline, le chlorure de 4-(3-méthyl-6-éthoxy-1,3-benzothiazol-3-ium-2-yl)-N,N-diméthylaniline, le chlorure de 4-(3-benzyl-1,3-benzothiazol-3-ium-2-yl)-N,N-diméthylaniline, le chlorure de 4-(3-méthyl-5-éthoxy-1,3-benzothiazol-3-ium-2-yl)-N,N-diméthylaniline, le chlorure de 4-(3-benzyl-5-éthoxy-1,3-benzothiazol-3-ium-2-yl)-N,N-diméthylaniline, le chlorure de 4-(3-benzyl-5-éthoxy-1,3-benzothiazol-3-ium-2-yl)-N,N-diméthylaniline, le chlorure de 4-(6-méthyl-1,3-benzothiazol-3-ium-2-yl)-N,N-diéthylaniline, le chlorure de 4-(3-benzyl-6-méthyl-1,3-benzothiazol-3-ium-2-yl)-N,N-diéthylaniline, le chlorure de 4-(3,6-diméthyl-1,3-benzothiazol-3-ium-2-yl)-N,N-diéthylaniline, le chlorure de 4-(3-benzyl-5-méthyl-1,3-benzothiazol-3-ium-2-yl)-N,N-diéthylaniline, le chlorure de 4-(3,5-diméthyl-1,3-benzothiazol-3-ium-2-yl)-N,N-diéthylaniline, le chlorure de 4-(3-méthyl-6-éthoxy-1,3-benzothiazol-3-ium-2-yl)-N,N-diéthylaniline, le chlorure de 4-(3-benzyl-1,3-benzothiazol-3-ium-2-yl)-N,N-diéthylaniline, le chlorure de 4-(3-méthyl-5-éthoxy-1,3-benzothiazol-3-ium-2-yl)-N,N-diéthylaniline, le chlorure de 4-(3-benzyl-5-éthoxy-1,3-benzothiazol-3-ium-2-yl)-N,N-diéthylaniline, le chlorure de 4-(3-benzyl-5-éthoxy-1,3-benzothiazol-3-ium-2-yl)-N,N-diéthylaniline et les mélanges de ceux-ci.

6. Composition selon une des revendications précédentes **caractérisée en ce que** la composition comprend en outre au moins une source d'ions Cu²⁺.

7. Composition selon la revendication 6 **caractérisée en ce que** la source d'ions Cu²⁺ est choisie dans le groupe constitué par CuSO₄, CuBr₂, CuO, Cu(OH)₂ et les mélanges de ceux-ci.

8. Composition selon une des revendications précédentes **caractérisée en ce que** la composition comprend en outre au moins une source d'ions Fe²⁺, la concentration des ions Fe²⁺ et des ions Fe³⁺ étant de préférence identique.

9. Composition selon la revendication 8 **caractérisée en ce que** la source d'ions Fe²⁺ est FeSO₄ et la source d'ions Fe³⁺ est Fe₂(SO₄)₃.

10. Composition selon une des revendications précédentes **caractérisée en ce que** la composition comprend moins de 100 mg/l, de préférence moins de 50 mg/l, et mieux encore moins de 25 mg/l d'ions Cl¹⁻.

11. Composition selon une des revendications précédentes **caractérisée en ce que** la composition est sensiblement exempte d'acides organiques et de sels d'acides organiques.

12. Composition selon une des revendications précédentes **caractérisée en ce que** la concentration de l'agent d'affinage de gravure répondant à la formule I va de 1 à 1000 mg/l, de préférence de 1 à 300 mg/l, et mieux encore de 1 à 100 mg/l.

13. Composition selon une des revendications précédentes **caractérisée en ce que** la concentration des ions Br⁻ va de 1 à 200 mg/l, de préférence de 1 à 100 mg/l, et mieux encore de 1 à 25 mg/l.

14. Procédé de microgravure de surfaces de cuivre ou d'alliage de cuivre **caractérisé par** les étapes de procédé suivantes :
i) se procurer un substrat ayant une surface de cuivre ou d'alliage de cuivre,
ii) mettre ladite surface en contact avec une composition de nettoyage,
iii) mettre ladite surface en contact avec une composition selon une des revendications précédentes dans une première cuve,
dans lequel pendant la mise en contact le cuivre est oxydé en ions Cu²⁺ et les ions Cu²⁺ sont révélés dans ladite composition, tandis que les ions Fe³⁺ sont simultanément réduits en ions Fe²⁺.

15. Procédé selon la revendication 14 **caractérisé en ce que** le procédé comprend en outre les étapes de procédé :
iv) transférer une partie de ladite composition après mise en contact avec le substrat dans une deuxième cuve,
ladite deuxième cuve comprenant une anode et une cathode et
v) réduire lesdits ions Cu²⁺ en cuivre tout en oxydant les ions Fe²⁺ en ions Fe³⁺ en appliquant un courant entre ladite anode et ladite cathode.
